(19) Europäisches Patentamt
European Patent Office
Office européen des brevets

(11) **EP 2 660 638 B1**

(12) **EUROPEAN PATENT SPECIFICATION**

(45) Date of publication and mention
of the grant of the patent:
**02.12.2015 Bulletin 2015/49**

(51) Int Cl.:
***G02B 9/34*** *(2006.01)*        ***G03F 7/20*** *(2006.01)*

(21) Application number: **11852300.0**

(86) International application number:
**PCT/CN2011/083616**

(22) Date of filing: **07.12.2011**

(87) International publication number:
**WO 2012/089002 (05.07.2012 Gazette 2012/27)**

(54) **LARGE VIEW FIELD PROJECTION LITHOGRAPHY OBJECTIVE**

PROJEKTIONSLITHOGRAPHIEOBJEKTIV MIT GROSSEM BLICKFELD

OBJECTIF DE LITHOGRAPHIE PAR PROJECTION À GRAND CHAMP OPTIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **31.12.2010 CN 201010619283**

(43) Date of publication of application:
**06.11.2013 Bulletin 2013/45**

(73) Proprietor: **Shanghai Micro Electronics
Equipment Co., Ltd.
Shanghai 201203 (CN)**

(72) Inventors:
• **WU, Heng
Shanghai 201203 (CN)**
• **HUANG, Ling
Shanghai 201203 (CN)**
• **LIU, Guogan
Shanghai 201203 (CN)**

(74) Representative: **Tischner, Oliver
Lavoix
Bayerstrasse 83
80335 München (DE)**

(56) References cited:
EP-A2- 0 721 150        CN-A- 101 107 570
CN-A- 101 231 378        DE-A1- 19 905 203
JP-A- 2000 356 741        JP-A- 2006 147 809
US-A- 5 808 814        US-A- 5 969 803
US-A- 5 986 824

**Description**

**TECHNICAL FIELD**

The present invention relates in general to semiconductor processing technologies, and more particularly, to a large field projection objective for use in projection optical systems of lithography tools.

**BACKGROUND**

Currently, in the field of semiconductor processing, there are increasing demands for high-throughput projection optical systems with millimeter-level resolution. In order to obtain a high throughput, stepper-type lithography tools generally adopt a large exposure field. Moreover, in order to be adapted for reticle size, some of them employ optical systems with a magnification of 1.25X or 1.6X.

Japanese patent publication No.2000199850 discloses a 1.6X projection objective for lithography using exposure light with a wavelength of G-line or H-line and having a 117.6 mm field of view and a numerical aperture (NA) of 0.1 on a wafer surface. The projection objective is a multi-lens system consisting of 38 lenses and including an aspheric surface.

Moreover, Japanese patent publication No. 2006267383 discloses a 1.25X projection objective for lithography using I-line with a wavelength band of $\pm 3$ nm as the exposure light and has a partial field of 93.5 mm.

Furthermore, Japanese patent publication No. 2007079015 discloses another 1.25X projection objective also using I-line with a wavelength band of $\pm 1.5$ nm as the exposure light and has a partial field of 93.5 mm.

Indicated as above, such large exposure field design is dominant in the field of liquid crystal display (LCD) lithography tool, and meanwhile, in order to be adapted for reticle size, many optical systems adopt projection objectives with a magnification of higher than 1X, and even close to 2X. According to these conventional technologies in combination with consideration of indeed demands, there is a need to develop a projection objective with a magnification of 2X.

**SUMMARY OF THE INVENTION**

The present invention is directed to the provision of a large field projection objective as defined in claim 1 which is able to correct multiple types of aberrations, in particular, distortions, field curvatures, astigmatisms, axial chromatic aberrations and magnification chromatic aberrations, and obtain telecentricity both on the object and image sides.

In one embodiment, a projection objective for lithography which focuses and images a pattern of a reticle onto a wafer successively comprises, from the reticle and along an optical axis: a first lens group G31 having a positive refractive power; a second lens group G32 having a positive refractive power; a third lens group G33 having a positive refractive power; and a fourth lens group G34 having a positive refractive power, wherein following formulae are satisfied:

$$1.8 < |fG32/ fG31| < 5.4$$

$$0.57 < |fG33/ fG34| < 0.97$$

$$0.19 < |fG33/ fG32| < 0.5$$

where $f_{G31}$ is a focal length of the first lens group G31, $f_{G32}$ is a focal length of the second lens group G32, $f_{G33}$ is a focal length of the third lens group G33, and $f_{G34}$ is a focal length of the fourth lens group G34.

Preferably, the first lens group G31 comprises at least four lenses. Additionally, the second lens group G32 comprises at least six lenses and includes at least two pairs of lenses each consisting of a positive lens and a negative lens adjacent to the positive lens. Moreover, the third lens group G33 comprises at least four lenses and includes a sub-lens group G33-1n having a positive refractive power, the sub-lens group G33-1n including at least two adjacent lenses of the third lens group G33 both of which have a positive refractive power. Furthermore, the fourth lens group G34 comprises at least six lenses and includes a sub-lens group G34-1n having a positive refractive power, the sub-lens group G34-1n including at least three directly successively arranged lenses of the fourth lens group G34 all of which have a positive refractive power. The following formulae are satisfied:

$$1.03 < |f_{el\_max} / f_{G31}| < 1.95$$

$$0.34 < |f_{G33\text{-}1n} / f_{G33}| < 0.87$$

$$0.21 < |f_{G34\text{-}1n} / f_{G34}| < 0.47$$

where $f_{el\_max}$ is a focal length of a lens of the first lens group G31 which has a greatest refractive power in the first lens group G31, $f_{G33\text{-}1n}$ is a focal length of the sub-lens group G33-1n of the third lens group G33, and $f_{G34\text{-}1n}$ is a focal length of the sub-lens group G34-1n of the fourth lens group G34.

Preferably, the second lens group G32 includes at least a positive lens and a negative lens directly adjacent to the positive lens and the following formula is satisfied:

$$1.23 < V_{G32\text{-}P} / V_{G32\text{-}N} < 1.85$$

where $V_{G32\text{-}P}$ is an Abbe number of the positive lens of the second lens group G32, and $V_{G32\text{-}N}$ is an Abbe number of the negative lens of the second lens group G32 that is directly adjacent to the positive lens.

Preferably, the second lens group G32 includes at least a positive lens and a negative lens directly adjacent to the positive lens, and the following formula is satisfied:

$$1.59 < V_{G32\text{-}P} / V_{G32\text{-}N} < 2.65$$

where $V_{G32\text{-}P}$ is an Abbe number of the positive lens of the second lens group G32, and $V_{G32\text{-}N}$ is an Abbe number of the negative lens of the second lens group G32 that is directly adjacent to the positive lens.

Preferably, the two adjacent positive lenses of the sub-lens group G33-1n of the third lens group G33 satisfy the following formula:

$$0.75 < f_{41} < f_{42} < 1$$

where $f_{41}$ is a focal length of the lens disposed upstream in the direction from the reticle to the wafer, and $f_{42}$ is a focal length of the lens disposed downerstream in the direction from the reticle to the wafer.

Preferably, the projection objective is made of at least two groups of high refractive index mateirals and at least two groups of low refractive index mateirals.

Preferably, the high refractive index mateirals are mateirals having a refractive index of higher than 1.55 at I-line, including a first material group whose materials have refractive indices which are higher than 1.55 at I-line and Abbe numbers which are higher than 45 and a second material group whose materials have refractive indices which are higher than 1.55 at I-line and Abbe numbers which are higher than 50; the low refractive index mateirals are mateirals having a refractive index of lower than 1.55 at I-line, including a third material group whose materials have refractive indices which are lower than 1.55 at I-line and Abbe numbers which are lower than 55 and a fourth material group whose materials have a refractive indices which are lower than 1.55 at I-line and Abbe numbers which are higher than 60.

Preferably, both of a first lens of the first lens group G31 and a last lens of the fourth lens group G34 are made of a material of the first material group.

Preferably, each of the first, second, third and fourth lens groups includes at least one lens made of the a material of the first or second material group.

Preferably, each of the first, second and fourth lens groups includes at least one lens made of a material of the first material group.

Preferably, the third lens group includes at least one lens made of a material of the second material group.

Preferably, the second lens group includes at least one pair of lenses each of which has a convace surface facing a convace surface of the other lens. Additionally, the third lens group includes at least one meniscus lens which has a concanve surface facing an image plane. Moreover, the fourth lens group includes at least one meniscus lens which has a concave surface facing an object plane.

The present invention achieves, with a smaller number of lenses, a 2X projection obj ective for lithography which has a partial field of view of not smaller than 100 mm and is suited for I-line light with a wavelength band of ±5nm which can ensure a sufficient exposure light intensity. At the same time, the present invention also achieves, with a relatively simple structure, the demanded millimeter-level resolution as well as the correction of distortions, field curvatures, astigmatisms and chromatic aberrations in a large field.

## BRIEF DESCRIPTION OF THE DRAWINGS

To provide a more complete understanding of the present invention and its advantages, reference is made to the following detailed description on example embodiments, taken in conjunction with the accompanying drawings, in which:

FIG.1 schematically illustrates the optical structure of a projection objective for lithography according to an embodiment of the present invention;
FIG.2 shows a curve representing the distortions in an embodiment of the present invention;
FIG.3 shows curves representing telecentricity on the object and image sides in an embodiment of the present invention; and
FIG.4 shows curves representing aberrations in an embodiment of the present invention.

## DETAILED DESCRIPTION

Several exemplary embodiments of the present invention will be described below with reference to the accompanying drawings.

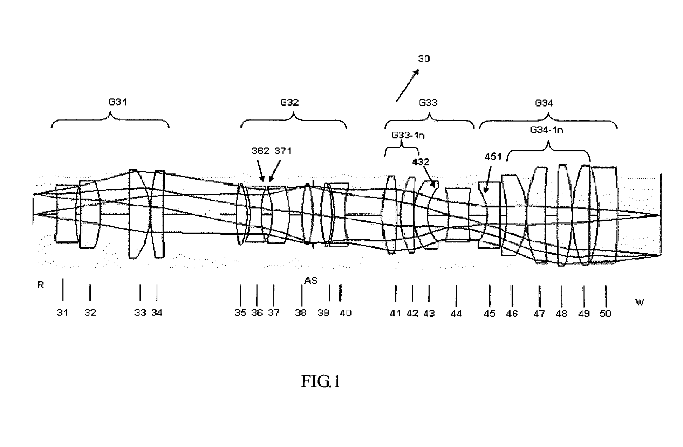

Referring to FIG.1, a projection objective 30 according to an embodiment of the present invention includes twenty lenses, and specifications of which are shown in the following Table 1.

Table 1

| Working Wavelength | @365 nm ± 5nm |
|---|---|
| Image-side Numerical Aperture (NA) | 0.1 |
| Magnification | -2 |
| Image-side Filed of View (diameter) | 200 mm |
| Object-Image Distance | 1500 mm |

The projection objective 30 is composed of twenty lenses. The twenty lenses are all spherical lenses and can be divided into four lens groups G31, G32, G33 and G34 each having a positive refractive power.

The first lens group G31 consists of four lenses, refractive powers of which are negative, positive, positive and positive, respectively.

The second lens group G32 consists of six lenses, refractive powers of which are positive, negative, negative, positive, positive and negative, respectively. Moreover, the second lens group G32 includes at least two pairs of lenses each consisting of a positive lens and a negative lens adjacent to the positive lens. Furthermore, the second lens group G32 includes at least one pair of lenses each of which has a convace surface facing a convace surface of the other lens.

The third lens group G33 consists of four lenses, refractive powers of which are positive, positive, negative and negative, respectively. Additionally, the third lens group G33 includes a sub-lens group G33-1n having a positive refractive power, the sub-lens group G33-1n including at least two adjacent lenses of the third lens group G33 both of which have a positive refractive power. Moreover, the third lens group G33 includes at least one meniscus lens which has a concave surface facing an image plane.

The fourth lens group G34 consists of six lenses, refractive powers of which are negative, positive, positive, positive, positive and negative, respectively. Moreover, the fourth lens group G34 includes a sub-lens group G34-1n having a positive refractive power, the sub-lens group G34-1n including at least three directly succesively arranged lenses of the fourth lens group G34 all of which have a positive refractive power. In addition, the fourth lens group G34 includes at least one meniscus lens which has a concave surface facing an object plane.

The projection objective 30 is made of at least two groups of high refractive index mateirals and at least two groups of low refractive index mateirals, wherein the high refractive index mateirals may be those having a refractive index of higher than 1.55 for I-line light, including a first material group whose materials have refractive indices which are higher than 1.55 at I-line and Abbe numbers which are higher than 45 and a second material group whose materials have refractive indices which are higher than 1.55 at I-line and Abbe numbers which are higher than 50, while the low refractive index mateirals may be those having a refractive index of lower than 1.55 at I-line, including a third material group whose materials have refractive indices which are lower than 1.55 at I-line and Abbe numbers which are lower than 55 and a fourth material group whose materials have refractive indices which are lower than 1.55 at I-line and Abbe numbers which are higher than 60.

In a preferred embodiment, each of the first, second, third and fourth lens groups includes at least one lens made of a material of the first or second material group. Each of the first, second and fourth lens groups includes at least one lens made of the a material of first material group. The third lens group includes at least one lens made of a material of the second material group. Furthermore, both of a first lens of the first lens group G31 and a last lens of the fourth lens group G34 are preferably made of a material of the first material group.

The first lens group G31 consists of four lenses 31, 32, 33 and 34, among which: the lens 31 is a biconcave negative lens; the lens 32 is a positive meniscus lens having a concave surface facing a reticle surface R; and both the lenses 33 and 34 are positive lenses. Moreover, the lenses 31, 32 and 34 are each made of a material of the first or third material group while the lens 33 is made of a material of the second or fourth material group.

The second lens group G32 consists of six lenses 35, 36, 37, 38, 39 and 40, among which: the lens 35 is a biconvex positive lens; the lenses 36 and 37 are negative lenses, and the lens 36 has a concave surface 362 facing a concave surface 371 of the lens 37; the lenses 38 and 39 are positive lenses; and the lens 40 is a negative lens. Additionally, lenses 35, 36, 38 and 39 are each made of a material of the second or fourth material group while lenses 37 and 40 are each made of a material of the first or third material group.

The third lens group G33 consists of four lenses 41, 42, 43 and 44, among which: both the lenses 41 and 42 have a positive refractive power; both the lenses 43 and 44 have a negative refractive power; and the lens 43 is a meniscus lens having a concave surface 432 facing a wafer surface. Moreover, all the lenses 41, 42, 43 and 34 are each made of a material of the second or fourth material group.

The fourth lens group G34 consists of six lenses 45, 46, 47, 48, 49 and 50, refractive powers of which are negative, positive, positive, positive, positive and negative, respectively. The lens 45 has a flat rear surface and a concave surface facing the reticle surface. In addition, the lenses 45 and 47 are each made of a material of the second or fourth material group while the lenses 46, 48, 49 and 50 are each made of a material of the first or third material group.

Relationship among parameters of the lens groups G31, G32, G33 and G34 and their sub-lens groups can be expressed by the following formulae which further determines basic conditions for optimizing the imaging quality of the projection objective,

$$1.8 < |f_{G32} / f_{G31}| < 5.4 \qquad (1)$$

$$0.57 < |f_{G33} / f_{G34}| < 0.97 \qquad (2)$$

$$0.19 < |f_{G33} / f_{G32}| < 0.5 \qquad (3)$$

$$1.03 < |f_{el\_max} / f_{G31}| < 1.95 \qquad (4)$$

$$0.34 < |f_{G33-1n} / f_{G33}| < 0.87 \qquad (5)$$

$$0.21 < |f_{G34-1n} / f_{G34}| < 0.47 \qquad (6)$$

$$0.75 < f_{41} / f_{42} < 1 \qquad (7)$$

$$1.23 < V_{G32-P} / V_{G32-N} < 1.85 \qquad (8)$$

$$1.59 < V_{G32-P} / V_{G32-N} < 2.65 \qquad (9)$$

where: $f_{G31}$ is a focal length of the first lens group G31; $f_{G32}$ is a focal length of the second lens group G32; $f_{G33}$ is a focal length of the third lens group G33; $f_{G34}$ is a focal length of the fourth lens group G34; $f_{el\_max}$ is a focal length of a lens of the first lens group G31 which has a greatest refractive power in the first lens group G31; $f_{G33-1n}$ is a focal length of the sub-lens group G33-1n of the third lens group G33; $f_{G34-1n}$ is a focal length of the sub-lens group G34-1n of the fourth lens group G34; $f_{41}$ is a focal length of the lens 41 that is disposed upstream in the direction from the reticle to the wafer of the two adjacent lenses 41 and 42 of the sub-lens group G33-1n of the third lens group G33, while $f_{42}$ is a focal length of the other lens 42 that is disposed downstream in the direction; and $V_{G32-P}$ and $V_{G32-N}$ are Abbe numbers of a positive lens of the second lens group G32 and a negative lens of the second lens group G32 that is adjacent to the positive lens, respectively.

As described above, in this embodiment, focal lengths of the positive lenses 41 and 42 of the sub-lens group G33-1n of the third lens group G33 are indicated as $f_{41}$ and $f_{42}$ according to a relationship between their positions in the direction from the reticle to the wafer and satisfy the formula $f_{41} < f_{42}$. These two positive lenses are used to gradually compress the light eminated from the second lens group and thus improve the correction of field curvatures.

Moreover, the foregoing formulae (1) to (9) have defined structural relations of the lens groups G31, G32, G33, G34 and their sub-lens groups in correcting aberrations.

Specific design values of the projection objective in this embodiment are given in Table 2, in which, a positive radius of a surface indicates that a center of curvature of the surface is on its right side, and similarly, a negative radius of a surface indicates that a center of curvature of the surface is on its left side; a thickness of an optical member or a spacing between two optical members is defined as a distance from a current surface to the next surface along the optical axis; and the unit of all dimensions is millimeter.

In Table 2, there is further indicated: surface number "S#", aperture stop (AS) "STOP", and infinity "INF" in the column of Radius.

Table 2

| S# | Radii | Thicknesses and Spacings | Materials | Remarks |
|---|---|---|---|---|
| OBJ | INF | 47.0004 | | Object-side Working Distance |
| 1 | -341.576 | 34.29386 | PBL25Y | L1 |
| 2 | 1185.168 | 12.21087 | | |
| 3 | -222.541 | 45.3383 | PBM18Y | L2 |
| 4 | -161.39 | 71.85194 | | |
| 5 | INF | 47.00983 | SFSL5Y | L3 |
| 6 | -183.839 | 1 | | |
| 7 | 844.4744 | 26.49825 | PBL25Y | L4 |
| 8 | INF | 194.2484 | | |
| 9 | 414.9022 | 26.25041 | SFSL5Y | L5 |
| 10 | -243.136 | 6.168656 | | |
| 11 | -176.468 | 23 | BSM51Y | L6 |
| 12 | 254.7796 | 31.33048 | | |
| 13 | -178.33 | 44.40986 | PBM18Y | L7 |
| 14 | -232.626 | 29.66318 | | |
| 15 | 403.048 | 25.85819 | SFSL5Y | L8 |
| 16 | -230.792 | 1 | | |
| 17 | INF | 30.67998 | | (STOP) |
| 18 | 313.9001 | 25.88924 | SFSL5Y | L9 |
| 19 | -331.934 | 6.301843 | | |
| 20 | -270.11 | 23 | PBM18Y | L10 |

(continued)

| S # | Radii | Thicknesses and Spacings | Materials | Remarks |
|---|---|---|---|---|
| 21 | 288.0486 | 64.21258 | | |
| 22 | 329.4014 | 27.44817 | SFSL5Y | L11 |
| 23 | -680.652 | 2.530852 | | |
| 24 | 186.3488 | 28.49718 | BSL7Y | L12 |
| 25 | 3221.473 | 1.000735 | | |
| 26 | 161.8902 | 29.67068 | BSM51Y | L13 |
| 27 | 105.8729 | 64.02459 | | |
| 28 | -238.698 | 48.93309 | BSM51Y | L14 |
| 29 | 389.3077 | 38.0038 | | |
| 30 | -117.901 | 23 | BSM51Y | L15 |
| 31 | INF | 20.13205 | | |
| 32 | -320.124 | 46.94477 | PBM18Y | L16 |
| 33 | -226.249 | 4.830725 | | |
| 34 | 317.7772 | 49.397 | BSL7Y | L17 |
| 35 | 5543.824 | 32.52187 | | |
| 36 | 345.6422 | 49.34704 | PBM18Y | L18 |
| 37 | -1234.86 | 1 | | |
| 38 | 330.8498 | 49.41093 | PBM18Y | L19 |
| 39 | INF | 27.72791 | | |
| 40 | -434.844 | 37.4797 | PBM18Y | L20 |
| 41 | -12935.3 | 100.8894 | | Image-side Working Distance |
| IMG | INF | 0 | | |

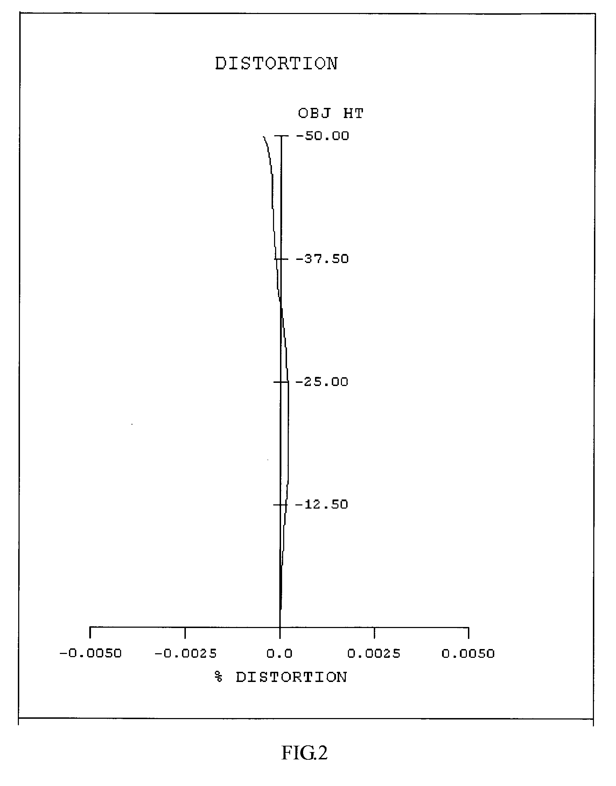

FIG.2 shows that the projection objective 30 of this embodiment has a good performance in distortion inhibition.

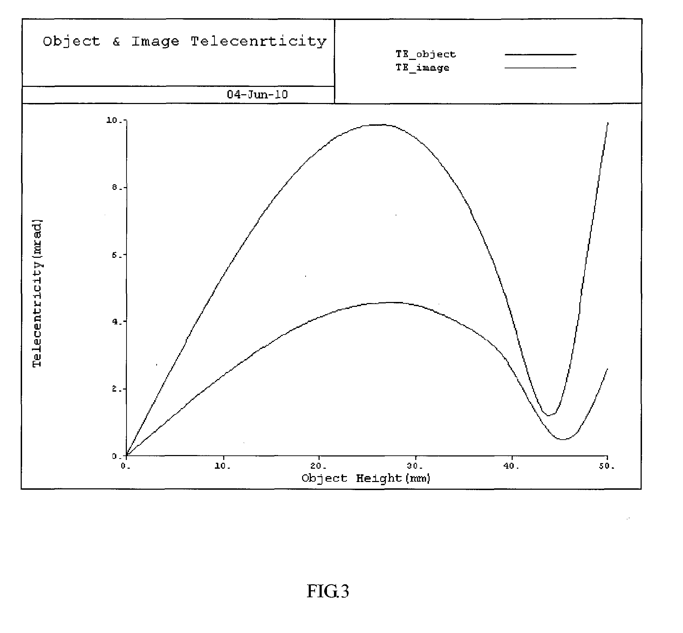

FIG.3 shows that telecentricity is corrected to about 3 mrad on the object side and to about 10 mrad on the image side of the projection objective 30.

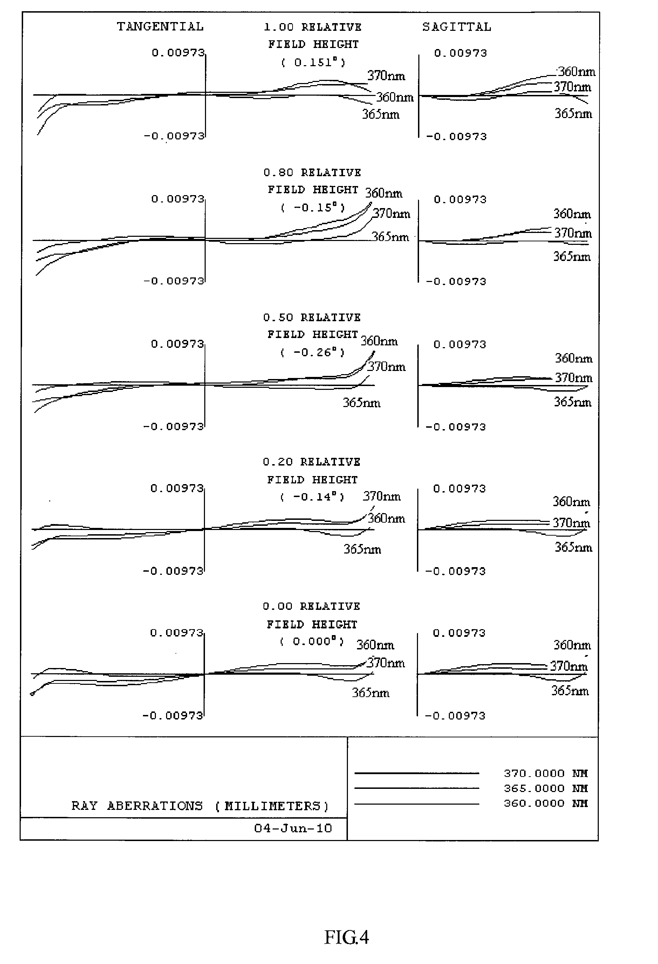

Moreover, the aberration curves in FIG.4 indicate that the projection objective 30 has a good performance in image quality correction, and that a high quality of images at I-line±5nm has been achieved.

In a word, the projection objectives described in the description are merely several preferable embodiments of the invention which are provided solely for the purpose of describing but not limiting the invention in any way. Any technical solutions which are obtained by those skilled in the art through logical analysis, reasoning or limited experiment in light of the conception of the invention are within the scope as defined in the appended claims.

## Claims

1. A lithography projection objective (30) for focusing and imaging a pattern of a reticle (R) onto a wafer (W) consisting of, from the reticle and along an optical axis:

    a first lens group (G31) having a positive refractive power;
    a second lens group (G32) having a positive refractive power;
    a third lens group (G33) having a positive refractive power; and
    a fourth lens group (G34) having a positive refractive power,

wherein the following formulae are satisfied:

$$1.8 < |f_{G32}/f_{G31}| < 5.4$$

$$0.57 < |f_{G33}/f_{G34}| < 0.97$$

$$0.19 < |f_{G33}/f_{G32}| < 0.5$$

where $f_{G31}$ is a focal length of the first lens group (G31), $f_{G32}$ is a focal length of the second lens group (G32), $f_{G33}$ is a focal length of the third lens group (G33), and $f_{G34}$ is a focal length of the fourth lens group (G34), wherein:
the first lens group (G31) consists of four lenses (31, 32, 33, 34);
the second lens group (G32) consists of six lenses (35, 36, 37, 38, 39, 40) which includes two pairs of lenses (35, 36; 39, 40) each consisting of a positive lens (35, 39) and a negative lens (36, 40) adjacent to the positive lens;
the third lens group (G33) consists of four lenses (41, 42, 43, 44) and includes a sub-lens group (G33-1n) having a positive refractive power, the sub-lens group (G33-1n) including two adjacent lenses (41, 42) of the third lens group (G33) both of which have a positive refractive power;
the fourth lens group (G34) consists of six lenses (45, 46, 47, 48, 49, 50) and includes a sub-lens group (G34-1n) having a positive refractive power, the sub-lens group (G34-1n) including at least three directly successively arranged lenses (46, 47, 48, 49) of the fourth lens group (G34) all of which have a positive refractive power; and
the following formulae are satisfied:

$$1.03 < |f_{el\_max}/f_{G31}| < 1.95$$

$$0.34 < |f_{G33-1n}/f_{G33}| < 0.87$$

$$0.21 < |f_{G34-1n}/f_{G34}| < 0.47$$

where $f_{el\_max}$ is a focal length of a lens of the first lens group (G31) which has a greatest refractive power in the first lens group (G31), $f_{G33-1n}$ is a focal length of the sub-lens group (G33-1n) of the third lens group (G33), and $f_{G34-1n}$ is a focal length of the sub-lens group (G34-1n) of the fourth lens group (G34).

2. The lithography projection objective (30) according to claim 1, wherein the second lens group (G32) includes at least a positive lens (35, 39) and a negative lens (36, 40) directly adjacent to the positive lens (35, 39), and wherein the following formula is satisfied:

$$1.23 < V_{G32-P}/V_{G32-N} < 1.85$$

where $V_{G32-P}$ is an Abbe number of the positive lens (35, 39) of the second lens group (G32), and $V_{G32-N}$ is an Abbe number of the negative lens (36, 40) of the second lens group (G32) that is directly adjacent to the positive lens (35, 39).

3. The lithography projection objective (30) according to claim 1, wherein the second lens group (G32) includes at least a positive lens (35, 39) and a negative lens (36, 40) directly adjacent to the positive lens (35, 39), and wherein the following formula is satisfied:

$$1.59 < V_{G32-P}/V_{G32-N} < 2.65$$

where $V_{G32-P}$ is an Abbe number of the positive lens (35, 39) of the second lens group (G32), and $V_{G32-N}$ is an Abbe number of the negative lens (36, 40) of the second lens group (G32) that is directly adjacent to the positive lens (35, 39).

4. The lithography projection objective (30) according to claim 1, wherein among the two adjacent positive lenses (41, 42) of the sub-lens group ($G_{33-1n}$) of the third lens group (G33), the one (42) disposed downstream in a direction from the reticle (R) to the wafer (W) has a greater focal length, and wherein the focal lengths of the two adjacent positive lenses (41, 42) are both within a range of 0.75 to 1.

5. The lithography projection objective (30) according to claim 1, wherein the projection objective (30) is made of at least two groups of high refractive index mateirals and at least two groups of low refractive index mateirals.

6. The lithography projection objective (30) according to claim 5, wherein:

the high refractive index mateirals are mateirals having a refractive index of higher than 1.55 at I-line, including a first material group whose materials have refractive indices which are higher than 1.55 at I-line and Abbe numbers which are higher than 45 and a second material group whose materials have refractive indices which are higher than 1.55 at I-line and Abbe numbers which are higher than 50;
the low refractive index mateirals are mateirals having a refractive index of lower than 1.55 at I-line, including a third material group whose materials have refractive indices which are lower than 1.55 at I-line and Abbe numbers which are lower than 55 and a fourth material group whose materials have a refractive indices which are lower than 1.55 at I-line and Abbe numbers which are higher than 60.

7. The lithography projection objective (30) according to claim6, wherein each of the first, second, third and fourth lens groups (G31, G32, G33, G34) includes at least one lens made of a material of the first or second material group.

8. The lithography projection objective (30) according to claim 6, wherein each of the first, second, and fourth lens groups (G31, G32, G33, G34) includes at least one lens made of a material of the first material group.

9. The lithography projection objective (30) according to claim 8, wherein both of a first lens (31) of the first lens group (G31) and a last lens (50) of the fourth lens group (G34) are made of a material of the first material group.

10. The lithography projection objective (30) according to claim 6, wherein the third lens group (G33) includes at least one lens made of a material of the second material group.

11. The lithography projection objective (30) according to claim 6, wherein:

the second lens group (G32) includes at least one pair of lenses (36, 37) which have convace surfaces (362, 371) facing each other;
the third lens group (G33) includes at least one meniscus lens (43) which has a concanve surface (432) facing an image plane; and
the fourth lens group (G34) includes at least one meniscus lens (45) which has a concanve surface (451) facing an object plane.

**Patentansprüche**

1. Lithographisches Projektionsobjektiv (30) zum Fokussieren und Abbilden eines Musters einer Netzstruktur (R) auf einem Wafer (W), von der Netzstruktur und entlang einer optischen Achse bestehend aus:

einer ersten Linsengruppe (G31) mit einer positiven Brechkraft;
einer zweiten Linsengruppe (G32) mit einer positiven Brechkraft;
einer dritten Linsengruppe (G33) mit einer positiven Brechkraft; und
einer vierten Linsengruppe (G34) mit einer positiven Brechkraft,
wobei die folgenden Formeln gelten:

$$1,8 < \left| f_{G32} / f_{G31} \right| < 5,4$$

$$0,57 < \left| f_{G33} / f_{G34} \right| < 0,97$$

$$0{,}19 < \left| f_{G33} / f_{G32} \right| < 0{,}5$$

wobei $f_{G31}$ eine Brennweite der ersten Linsengruppe (G31) ist, $f_{G32}$ eine Brennweite der zweiten Linsengruppe (G32) ist, $f_{G33}$ eine Brennweite der dritten Linsengruppe (G33) ist und $f_{G34}$ eine Brennweite der vierten Linsengruppe (G34) ist, wobei:

die erste Linsengruppe (G31) aus vier Linsen (31, 32, 33, 34) besteht;

die zweite Linsengruppe (G32) aus sechs Linsen (35, 36, 37, 38, 39, 40) besteht, die zwei Paaren von Linsen (35, 36; 39, 40) beinhalten, die jeweils aus einer positiven Linse (35, 39) und einer negativen Linse (36, 40) bestehen, die der positiven Linse benachbart angeordnet ist;

die dritte Linsengruppe (G33) aus vier Linsen (41, 42, 43, 44) besteht und eine Linsenteilgruppe (G33-1 n) mit einer positiven Brechkraft beinhaltet, wobei die Linsenteilgruppe (G33-1 n) zwei benachbarte Linsen (41, 42) der dritten Linsengruppe (G33) enthält, wobei beide eine positive Brechkraft aufweisen;

die vierte Linsengruppe (G34) aus sechs Linsen (45, 46, 47, 48, 49, 50) besteht und eine Linsenteilgruppe (G34-1 n) mit einer positiven Brechkraft beinhaltet, wobei die Linsenteilgruppe (G34-1 n) zumindest drei direkt aufeinanderfolgend angeordnete Linsen (46, 47, 48, 49) der vierten Linsengruppe (G34) enthält, wobei alle davon eine positive Brechkraft aufweisen; und

die folgenden Formeln gelten:

$$1{,}03 < \left| f_{el\_max}) / f_{G31} \right| < 1{,}95$$

$$0{,}34 < \left| f_{G33\text{-}1n} \; f_{G33} \right| < 0{,}87$$

$$0{,}21 < \left| f_{G34\text{-}1n} / f_{G34} \right| < 0{,}47$$

wobei $f_{el\_max}$ eine Brennweite einer Linse der ersten Linsengruppe (G31) ist, die die größte Brechkraft in der ersten Linsengruppe (G31) aufweist, $f_{G33\text{-}1n}$ eine Brennweite der Linsenteilgruppe (G33-1 n) der dritten Linsengruppe (G33) ist und $f_{G34\text{-}1n}$ eine Brennweite der Linsenteilgruppe (G34-1 n) der vierten Linsengruppe (G34) ist.

2. Lithographisches Projektionsobjektiv (30) nach Anspruch 1, wobei die zweite Linsengruppe (G32) zumindest eine positive Linse (35, 39) und eine negative Linse (36, 40) enthält, die der positiven Linse (35, 39) direkt benachbart angeordnet ist, und wobei die folgende Formel gilt:

$$1{,}23 < V_{G32\text{-}P} / V_{G32\text{-}N} < 1{,}85$$

wobei $V_{G32\text{-}P}$ eine Abbesche Zahl der positiven Linse (35, 59) der zweiten Linsengruppe (G32) ist und $V_{G32\text{-}N}$ eine Abbesche Zahl der negativen linse (36, 40) der zweiten Linsengruppe (G32) ist, die der positiven Linse (35, 39) direkt benachbart angeordnet ist.

3. Lithographisches Projektionsobjektiv (30) nach Anspruch 1, wobei die zweite Linsengruppe (G32) zumindest eine positive Linse (35, 39) und eine negative Linse (36, 40) enthält, die der positiven Linse (35, 39) direkt benachbart angeordnet ist, und wobei die folgende Formel gilt:

$$1{,}59 < V_{G32\text{-}P} / V_{G32\text{-}N} < 2{,}65$$

wobei $V_{G32\text{-}P}$ eine Abbesche Zahl der positiven Linse (35, 39) der zweiten Linsengruppe (G32) ist und $V_{G32\text{-}N}$ eine Abbesche Zahl der negativen Linse (36, 40) der zweiten Linsengruppe (G32) ist, die der positiven Linse (35, 39) direkt benachbart angeordnet ist.

4. Lithographisches Projektionsobjektiv (30) nach Anspruch 1, wobei von den zwei benachbarten positiven Linsen (41, 42) der Teillinsengruppe ($G_{33\text{-}1n}$) der dritten Linsengruppe (G33) die eine (42), die in einer Richtung von der Netzstruktur (R) zum Wafer (W) nachgeschaltet angeordnet ist, eine größere Brennweite hat, und wobei die Brennweiten der zwei benachbarten positiven Linsen (41, 42) jeweils innerhalb eines Bereichs von 0,75 bis 1 liegen.

**5.** Lithographisches Projektionsobjektiv (30) nach Anspruch 1, wobei das Projektionsobjektiv (30) aus zumindest zwei Gruppen von Materialien mit hohem Brechungsindex und zumindest zwei Gruppen von Materialien mit niedrigem Brechungsindex hergestellt ist.

**6.** Lithographisches Projektionsobjektiv (30) nach Anspruch 5, wobei:

die Materialien mit hohem Brechungsindex Materialien mit einem Brechungsindex von mehr als 1,55 auf der i-Linie sind, einschließlich einer ersten Materialgruppe, deren Materialien Brechungsindizes von mehr als 1,55 auf der i-Linie und Abbesche Zahlen von mehr als 45 aufweisen, und einer zweiten Materialgruppe, deren Materialien Brechungsindizes von mehr als 1,55 auf der i-Linie und Abbesche Zahlen von mehr als 50 aufweisen; die Materialien mit niedrigem Brechungsindex Materialien mit einem Brechungsindex von weniger als 1,55 auf der i-Linie sind, einschließlich einer dritten Materialgruppe, deren Materialien Brechungsindizes von weniger als 1,55 auf der i-Linie und Abbesche Zahlen von weniger als 55 aufweisen, und einer vierten Materialgruppe, deren Materialien Brechungsindizes von weniger als 1,55 auf der i-Linie und Abbesche Zahlen von weniger als 60 aufweisen.

**7.** Lithographisches Projektionsobjektiv (30) nach Anspruch 6, wobei jede der ersten, zweiten, dritten und vierten Linsengruppe (G31, G32, G33, G34) zumindest eine Linse enthält, die aus einem Material der ersten oder zweiten Materialgruppe ausgewählt ist.

**8.** Lithographisches Projektionsobjektiv (30) nach Anspruch 6, wobei jede der ersten, zweiten und vierten Linsengruppe (G31, G32, G33, G34) zumindest eine Linse enthält, die aus einem Material der ersten Materialgruppe ausgewählt ist.

**9.** Lithographisches Projektionsobjektiv (30) nach Anspruch 8, wobei sowohl eine erste Linse (31) der ersten Linsengruppe (G31) als auch eine letzte Linse (50) der vierten Linsengruppe (G34) aus einem Material der ersten Materialgruppe ausgewählt ist.

**10.** Lithographisches Projektionsobjektiv (30) nach Anspruch 6, wobei die dritte Linsengruppe (G33) zumindest eine Linse enthält, die aus einem Material der zweiten Materialgruppe hergestellt ist.

**11.** Lithographisches Projektionsobjektiv (30) nach Anspruch 6, wobei:

die zweite Linsengruppe (G32) zumindest ein Paar von Linsen (36, 37) enthält, die konkave Flächen (362, 371) aufweisen, die einander zugewandt sind; die dritte Linsengruppe (G33) zumindest eine Meniskuslinse (43) enthält, die eine konkave Fläche (432) aufweist, die einer Bildebene zugewandt ist; und die vierte Linsengruppe (G34) zumindest eine Meniskuslinse (45) enthält, die eine konkave Fläche (451) aufweist, die einer Objektebene zugewandt ist.


**Revendications**

**1.** Objectif de projection de lithographie (30) pour la mise au point et la formation d'une image d'un motif d'un réticule (R) sur une tranche de semiconducteur (W) et constitué, en partant du réticule et en suivant l'axe optique, des éléments suivant :

un premier groupe de lentilles (G31) ayant une réfringence positive ; un deuxième groupe de lentilles (G32) ayant une réfringence positive ; un troisième groupe de lentilles (G33) ayant une réfringence positive ; et un quatrième groupe de lentilles (G34) ayant une réfringence positive, dans lequel les formules suivantes sont satisfaites :

$$1,8 < \left| f_{G32} / f_{G31} \right| < 5,4$$

$$0{,}57 < \left| f_{G33} / f_{G34} \right| < 0{,}97$$

$$0{,}19 < \left| f_{G33} / f_{G32} \right| < 0{,}5$$

où $f_{G31}$ est la distance focale du premier groupe de lentilles (G31), $f_{G32}$ est la distance focale du deuxième groupe de lentilles (G32), $f_{G33}$ est la distance focale du troisième groupe de lentilles (G33) et $f_{G34}$ est la distance focale du quatrième groupe de lentilles (G34), dans lequel :

le premier groupe de lentilles (G31) est constitué de quatre lentilles (31, 32, 33, 34) ;

le deuxième groupe de lentilles (G32) est constitué de six lentilles (35, 36, 37, 38, 39, 40) qui comprennent deux paires de lentilles (35, 36 ; 39, 40) constituées chacune d'une lentille positive (35, 39) et d'une lentille négative (36, 40) adjacente à la lentille positive ;

le troisième groupe de lentilles (G33) est constitué de quatre lentilles (41, 42, 43, 44) et comprend un sous-groupe de lentilles (G33-1 n) ayant une réfringence positive, le sous-groupe de lentilles (G33-1 n) comprenant deux lentilles adjacentes (41, 42) du troisième groupe de lentilles (G33) qui ont chacune une réfringence positive ;

le quatrième groupe de lentilles (G34) est constitué de six lentilles (45, 46, 47, 48, 49, 50) et comprend un sous-groupe de lentilles (G34-1 n) ayant une réfringence positive, le sous-groupe de lentilles (G34-1 n) comprenant au moins trois lentilles agencées de manière directement consécutive (46, 47, 48, 49) du quatrième groupe de lentilles (G34) et ayant toutes une réfringence positive ; et

les formules suivantes sont satisfaites :

$$1{,}03 < \left| f_{el\_max} / f_{G31} \right| < 1{,}95$$

$$0{,}34 < \left| f_{G33-1n} / f_{G33} \right| < 0{,}87$$

$$0{,}21 < \left| f_{G34-1n} / f_{G34} \right| < 0{,}47$$

où $f_{el\_max}$ est la distance focale de la lentille du premier groupe de lentilles (G31) qui a la réfringence la plus élevée du premier groupe de lentilles (G31), $f_{G33-1n}$ est la distance focale du sous-groupe de lentilles (G33-1n) du troisième groupe de lentilles (G33), et $f_{G34-1n}$ est la distance focale du sous-groupe de lentilles (G34-1 n) du quatrième groupe de lentilles (G34).

**2.** Objectif de projection de lithographie (30) selon la revendication 1, dans lequel le deuxième groupe de lentilles (G32) comprend au moins une lentille positive (35, 39) et une lentille négative (36, 40) directement adjacente à la lentille positive (35, 39), et dans lequel la formule suivante est satisfaite :

$$1{,}23 < V_{G32-P} / V_{G32-N} < 1{,}85$$

où $V_{G32-P}$ est le nombre d'Abbe de la lentille positive (35, 39) du deuxième groupe de lentilles (G32) et $V_{G32-N}$ est le nombre d'Abbe de la lentille négative (36, 40) du deuxième groupe de lentilles (G32) qui est directement adjacente à la lentille positive (35, 39).

**3.** Objectif de projection de lithographie (30) selon la revendication 1, dans lequel le deuxième groupe de lentilles (G32) comprend au moins une lentille positive (35, 39) et une lentille négative (36, 40) directement adjacente à la lentille positive (35, 39), et dans lequel la formule suivante est satisfaite :

$$1{,}59 < V_{G32-P} / V_{G32-N} < 2{,}65$$

où $V_{G32-P}$ est le nombre d'Abbe de la lentille positive (35, 39) du deuxième groupe de lentilles (G32) et $V_{G32-N}$ est le nombre d'Abbe de la lentille négative (36, 40) du deuxième groupe de lentilles (G32) qui est directement adjacente à la lentille positive (35, 39).

4. Objectif de projection de lithographie (30) selon la revendication 1, dans lequel entre les deux lentilles positives adjacentes (41, 42) du sous-groupe de lentilles ($G_{33-1n}$) du troisième groupe de lentilles (G33), celle (42) qui se trouve en aval en allant du réticule (R) vers la tranche (W) a une distance focale supérieure, et dans lequel les distances focales des deux lentilles positives adjacentes (41, 42) se trouvent chacune dans une plage de 0,75 à 1.

5. Objectif de projection de lithographie (30) selon la revendication 1, dans lequel l'objectif de projection (30) est réalisé à partir d'au moins deux groupes de matériaux à indice de réfraction élevé et d'au moins deux groupes de matériaux à faible indice de réfraction.

6. Objectif de projection de lithographie (30) selon la revendication 5, dans lequel :

les matériaux à indice de réfraction élevé sont des matériaux ayant un indice de réfraction supérieur à 1,55 à la ligne I, comprenant un premier groupe de matériaux dont les matériaux ont des indices de réfraction qui sont supérieurs à 1,55 à la ligne I et des nombres d'Abbe qui sont supérieurs à 45 et un deuxième groupe de matériaux dont les matériaux ont des indices de réfraction qui sont supérieurs à 1,55 à la ligne I et des nombres d'Abbe qui sont supérieurs à 50 ;
les matériaux à faible indice de réfraction sont des matériaux ayant un indice de réfraction inférieur à 1,55 à la ligne I, comprenant un troisième groupe de matériaux dont les matériaux ont des indices de réfraction qui sont inférieurs à 1,55 à la ligne I et des nombres d'Abbe qui sont inférieurs à 55 et un quatrième groupe de matériaux dont les matériaux ont des indices de réfraction qui sont inférieurs à 1,55 à la ligne I et des nombres d'Abbe qui sont supérieurs à 60.

7. Objectif de projection de lithographie (30) selon la revendication 6, dans lequel chacun des premier, deuxième, troisième et quatrième groupes de lentilles (G31, G32, G33, G34) comprend au moins une lentille réalisée à partir d'un matériau du premier ou du deuxième groupe de matériaux.

8. Objectif de projection de lithographie (30) selon la revendication 6, dans lequel chacun des premier, deuxième, troisième et quatrième groupes de lentilles (G31, G32, G33, G34) comprend au moins une lentille réalisée à partir d'un matériau du premier groupe de matériaux.

9. Objectif de projection de lithographie (30) selon la revendication 8, dans lequel la première lentille (31) du premier groupe de lentilles (G31) et la dernière lentille (50) du quatrième groupe de lentilles (G34) sont réalisées chacune à partir d'un matériau du premier groupe de matériaux.

10. Objectif de projection de lithographie (30) selon la revendication 6, dans lequel le troisième groupe de lentilles (G33) comprend au moins une lentille réalisée à partir d'un matériau du deuxième groupe de matériaux.

11. Objectif de projection de lithographie (30) selon la revendication 6, dans lequel :

le deuxième groupe de lentilles (G32) comprend au moins une paire de lentilles (36, 37) qui présentent des surfaces convexes (362, 371) se faisant face ;
le troisième groupe de lentilles (G33) comprend au moins une lentille ménisque (43) qui présente une surface concave (432) faisant face à un plan image ; et
le quatrième groupe de lentilles (G34) comprend au moins une lentille ménisque (45) qui présente une surface concave (451) faisant face à un plan objet.

FIG.1

FIG.2

FIG.3

FIG.4

**REFERENCES CITED IN THE DESCRIPTION**

**Patent documents cited in the description**

- JP 2000199850 B
- JP 2006267383 B

- JP 2007079015 B